# EUROPEAN PATENT SPECIFICATION

(11) **EP 0 945 982 B1**
(45) Date of publication and mention of the grant of the patent: **11.02.2004**
(21) Application number: 99302215.1
(22) Date of filing: 23.03.1999
(51) Int. Cl.: H03K 5/156

(54) **Pulse amplifier with low duty cycle errors**
Differentieller Impulsverstärker mit konstantem Tastverhältnis
Amplificateur différentiel d' impulsions à rapport cyclique constant

(30) Priority: 27.03.1998 US 79668 P; 30.03.1998 CA 2233527
(43) Date of publication of application: 29.09.1999
(73) Proprietor: Zarlink Semiconductor AB, 175 26 Järfälla (SE)
(72) Inventor: Andersson, Bengt-Olov (Olle), 177 40 Järfälla (SE)
(74) Representative: McLean, Robert Andreas

(56) References cited:
- EP-A- 0 358 518
- EP-A- 0 451 378
- WO-A-95/22202
- WO-A-95/22206
- GB-A- 2 258 779
- US-A- 5 512 848

## Description

The present invention relates to a low power pulse amplifier, and more particularly to a low power pulse amplifier with a low duty cycle error at high input levels.

The duty cycle requirements for pulse amplifiers of this type exclude the use of single-ended amplifiers since clipping at higher amplitudes results in different clip levels and delays in the positive and negative directions.

Typically, for a single-ended input signal, an ordinary differential stage consisting of a differential pair of transistors produces asymmetrical delays in the positive and negative directions of the input signal if the input signal is large. The main reason for this is that the common source node for the differential pair will change its potential differently between large positive and large negative input signals.

When the input signal turns off the input transistor, the voltage of the common source node only changes a small amount due to the doubled current in the other transistor. In the other direction the common source node shorts to the output node and changes a substantial amount. One solution to this problem is to reduce the absolute delay times by increasing bandwidth. But this solution comes at the expense of increased current consumption.

GB-A-2,258,779 and EP-A-0,451,378 both disclose a pulse amplifier with a plurality of fully differential amplifier stages between an input and output. GB-A-2,258,779 employs complex circuitry that is not suited for low power applications. EP-A-0,451,378 addresses the problem of negative overshoot caused by capacitance at the common node and employs a bias voltage applied to the drain of the differential transistors.

An object of the present invention is to provide an improved pulse amplifier.

According to the present invention there is provided a pulse amplifier comprising an input for receiving input signals, an output, and a plurality of cascaded fully differential amplifier stages between said input and output, wherein each said amplifier stage comprises first and second transistors forming a differential pair and having a common node, and a pair of cascode transistors in series with said respective first and second transistors, each of said transistors having first and second main electrodes and a gate electrode, the gate electrodes of said first and second transistors receiving input signals for the amplifier stage, the second main electrodes of said first and second transistors being connected to the first main electrodes of said respective cascode transistors, characterized in that said amplifier further comprises a first series combination comprising a first load transistor in series with a first current source and having a first common connection point, and a second series combination comprising a second load transistor in series with a second current source and having a second common connection point, said first and second common connection points providing output signals for said amplifier stage and being connected to the second main electrodes of said respective cascode transistors, and wherein in the presence of large input signals one of the transistors of said differential pair is driven hard into conduction causing the first main electrode of its associated cascode transistor to be substantially shorted to said common node, thereby causing the voltage of the first main electrode of the associated cascode transistor to approach its gate voltage, and in turn causing a gradual reduction in the current flow through said associated cascode transistor and consequently a gradual reduction in the current flow through said one of the transistors of the differential pair that was driven into hard conduction.

In accordance with the invention fully differential gain stages, that is differential amplifiers with differential inputs and differential outputs, give more symmetrical delays and reduce the problem.

In one embodiment of the invention, the first and second current sources are connected in series with the series combinations of the first and second transistors and their associated cascode transistors, and the first and second load transistors are connected in parallel with said series combinations of said first and second transistors and their associated cascode transistors.

In an alternative embodiment of the invention the first and second current sources are connected in parallel with said series combinations of the first and second transistors and their associated cascode transistors, and the first and second load transistors are connected in series with said series combinations of first and second transistors and their associated cascode transistors.

The invention also preferably includes a biasing network and an offset canceling network.

The invention will now be described in more detail, by way of example only, with reference to the accompanying drawings, in which:-
Figure 1 is a block diagram of a multistage pulse amplifier with a low duty cycle;
Figure 2 is a schematic illustration of an amplifier stage with an NMOS input; and
Figure 3 is a schematic illustration of an alternative embodiment of the amplifier stage.

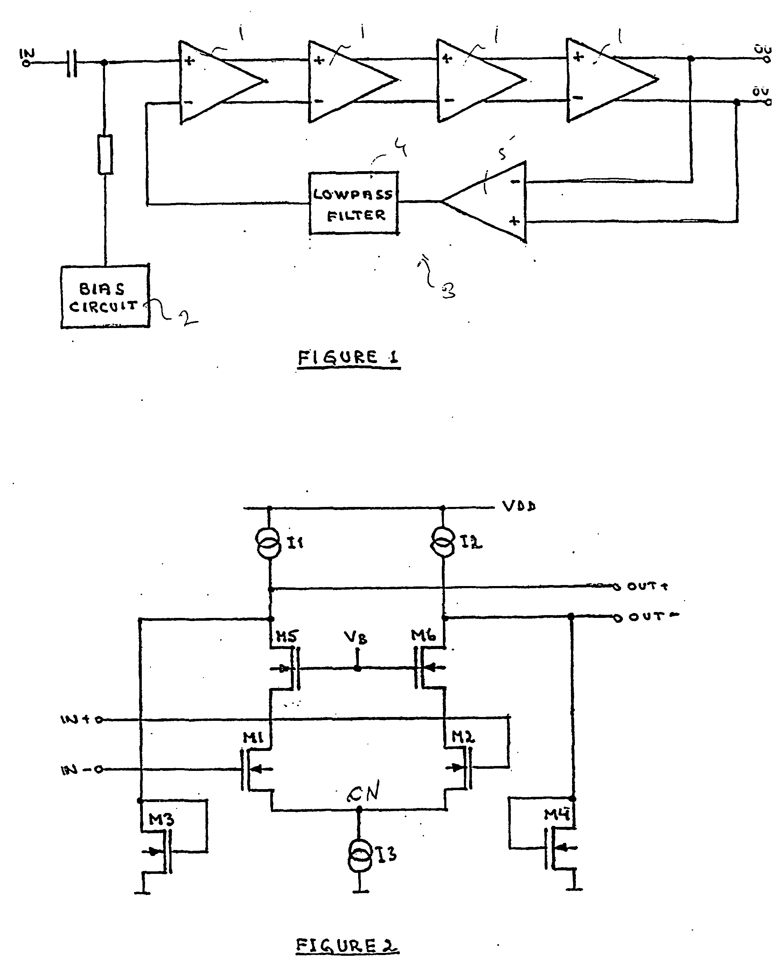

The pulse amplifier with low duty cycle shown in Figure 1 consists of several cascaded fully differential, i.e. differential in/differential out, amplifier stages 1, a biasing network 2, and an offset canceling network 3 consisting of a low pass filter 4 and an ordinary differential amplifier 5. The gain of the amplifier 5 and the cut-off frequency of the low pass filter 4 in the offset canceling network should be chosen so that the resulting high pass characteristic of the canceling network has a cut-off frequency below the frequencies contained in the input signal applied to the amplifier.

Figure 2 illustrates an amplifier stage 1 with a NMOS input, although it will be understood that the amplifier can be configured in opposite logic using PMOS components.

Differential input signals IN+, IN-, are applied to respective NMOS transistors M1, M2 having a common node CN and together forming a differential pair. Transistors M1, M2 are in series with respective cascode transistors M5, M6 providing respective differential outputs OUT+, OUT-. Current sources I₁, I₂ for the differential pair are connected to supply rail V_{DD}.

Load transistors M3 and M4 are connected in parallel with respective series combinations M1, M5 and M2, M6 to the same supply V_{DD} as the current sources I₁, I₂ for the differential pair M1, M2 in order to minimize the supply voltage needed to drive the amplifier. The two matching current sources I₁ and I₂ are larger than current source I, connected to common node CN to guarantee that there is always a current flowing through M3 and M4 even when the differential stage is fully saturated. This reduces the output voltage swing during clipping.

It is possible to place the load transistors M3 and M4 in series with the respective series combinations M1, M5 and M2, M6, in which case the current sources should be placed where the respective load transistors are located in the parallel configuration.

The two cascode transistors M5 and M6, which are provided between the drains of the differential pair and the two outputs OUT+, OUT-, minimize duty cycle errors for large input signals. The gate voltage to the cascode transistors is chosen to set the Vds of the differential pair above, but not substantially above, the saturation voltage of these transistors. This holds true as long as the amplifier circuit is not clipping due to large input signals.

The cascode transistors ultimately turn off if a large input signal charges the common source node of the differential pair toward the output dc level so this node will be held relatively constant for very large input signals resulting in significantly more symmetric delays in positive and negative directions.

In the presence of large input signals, one of the transistors of the differential pair, say M1, is driven hard into conduction, and its drain in effect gradually becomes shorted to the common node. The drain of transistor M1 is connected to the source of transistor M5, and consequently the voltage of the source of cascode transistor M5 approaches the voltage of its gate, so that the current flow through transistor M5 gradually reduces until it eventually turns off. This of course has the effect of gradually reducing the current flow through the associated differential transistor M1.

In a typical design the common node will change 75mV to 150mV before the limiting circuit is activated.

The gain is set by the ratio of transconductance in M1 and M3. It is advantageous to use the same type of transistors in both the differential pair and the load to minimize the gain variations due to process spread and the threshold voltage variations. In all normal cases the gain is larger than one, so M3 will have a lower transconductance than M1. With I₁ and I₂ being than I₃, the dc current in the load transistors M3 and M4 will be larger than in M1 and M2, so W/L for M3 and M4 has to be smaller than in M1 and M2 to move them deeper into strong inversion and lower the transconductance. This results in a larger Vgs for the load transistors than for the differential pair, so there will be enough voltage over the current source for the differential pair to function correctly if the input of one gain stage is dc coupled to the output of the previous stage.

The bias network generates the bias voltages for the current sources and the cascode transistors. With an ac coupled signal, the bias network also supplies the dc bias for the input node. In cases where the amplifier is powered on and off, the start-up time can be reduced if the offset cancellation feedback signal is held at a voltage near the dc input voltage while the amplifier is disabled.

The current sources I₁ to I₃ can be implemented as simple current mirrors or cascoded current mirrors if better PSRR (Power Supply Rejection Ratio) is required.

In an alternative embodiment, if, for instance, the gain is low or the output is ac coupled, the offset voltage at the output may be acceptable without offset cancellation. In this case the reference input is connected to a fixed voltage instead, typically the same voltage biasing the signal input.

The circuit can be turned inverted with all NMOS transistors replaced by PMOS transistors and vice versa.

The amplifiers can also be made variable gain amplifiers if the current source I₃ is made variable. A lower I₃ current will reduce the transconductance in the differential pair and also increase the current in the load transistors and increase their transconductance.

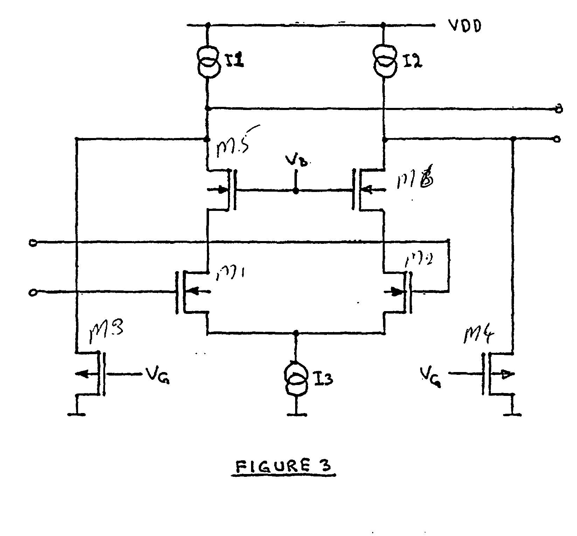

If the dc level at the outputs of the amplifier stage must be set at a different voltage than slightly above the NMOS threshold, the NMOS load transistors M3, M4 can be replaced by PMOS transistors with their sources tied to their outputs, the drains to Vss and their gates to a voltage V_{G}, which is approximately the desired output voltage minus a PMOS threshold voltage. This arrangement is shown in Figure 3. The drawback with this solution is a larger parameter variation due to process spread.

The pulse amplifier is general in nature and can be used in a wide range of applications. Signals should be ac coupled since the input common mode range is limited. In particular, it can amplify a Manchester coded data stream at 300 kbits/sec. The amplitude ranges from 5 mV pp up to the supply voltage and maintains a duty cycle error of less than 5%.

Advantages of the amplifier according to the present invention thus include:
- low duty cycle errors at high input levels due to well controlled clipping;
- low voltage operation by connecting the gain transistor and load transistor to the same supply rail; and
- the gain is relatively insensitive to temperature and process variations by the use of the same type of transistor as gain element and load.

As mentioned above, the load transistors M3 and M4 can be placed in series with the cascode transistors M5, M6, in which case they change places with the current sources I₁, I₂.

Although embodiments of the invention have been described above, it is not limited thereto and it will be apparent to those skilled in the art that numerous modifications form part of the present invention insofar as they do not depart from the scope of the claimed invention.

## Claims

1. A pulse amplifier comprising an input (IN) for receiving input signals, an output (OUT), and a plurality of cascaded fully differential amplifier stages (1) between said input and output, wherein each said amplifier stage (1) comprises first and second transistors (M1, M2) forming a differential pair and having a common node (CN), and a pair of cascode transistors (M5, M6) in series with said respective first and second transistors (M 1,M2), each of said transistors (M1, M2, M5, M6) having first and second main electrodes and a gate electrode, the gate electrodes of said first and second transistors receiving input signals (IN+, IN-) for the amplifier stage (1), the second main electrodes of said first and second transistors (M1, M2) being connected to the first main electrodes of said respective cascode transistors (M5, M6), **characterized in that** said amplifier (1) further comprises a first series combination comprising a first load transistor (M3) in series with a first current source (I1) and having a first common connection point, and a second series combination comprising a second load transistor in series with a second current source (12) and having a second common connection point, said first and second common connection points providing output signals for said amplifier stage and being connected to the second main electrodes of said respective cascode transistors, and wherein in the presence of large input signals one of the transistors (M1 or M2) of said differential pair is driven hard into conduction causing the first main electrode of its associated cascode transistor (M5 or M6) to be substantially shorted to said common node (CN), thereby causing the voltage of the first main electrode of the associated cascode transistor (M5 or M6) to approach its gate voltage, and in turn causing a gradual reduction in the current flow through said associated cascode transistor (M5 or M6) and consequently a gradual reduction in the current flow through said one (M1 or M2) of the transistors of the differential pair (M1, M2) that was driven into hard conduction.

2. A pulse amplifier as claimed in claim 1, wherein said first and second current sources (I1, I2) are connected in series with said series combinations of said first and second transistors (M1, M2) and their associated cascode transistors (M5, M6), and said first and second load transistors (M3, M4) are connected in parallel with said series combinations of said first and second transistors (M1, M2) and their associated cascode transistors (M5, M6).

3. A pulse amplifier as claimed in claim 1, wherein said first and second current sources (I1, I2) are connected in parallel with said series combinations of said first and second transistors (M1, M2) and their associated cascode transistors (M5, M6), and said first and second load transistors (M3, M4) are connected in series with said series combinations of said first and second transistors (M1, M2) and their associated cascode transistors (M5, M6).

4. A pulse amplifier as claimed in claim 1, wherein the gates of the cascode transistors (M5, M6) are connected to a voltage source (V_{B}) selected to set the source-drain voltage of said differential pair slightly above their saturation voltage, as long as the amplifier stage is not clipping due to large input signals.

5. A pulse amplifier as claimed in any of claims 1 to 4, wherein said first main electrode is the source, and said second main electrode is the drain.

6. A pulse amplifier as claimed in claim 5, further comprising a third current source (13) in series with said common node.

7. A pulse amplifier as claimed in claim 6, wherein the currents generated by said first and second current sources (I1, I2) are greater than the current generated by said third current source (I3) to ensure that current flows through said load transistors when said first and second transistors are saturated.

8. A pulse amplifier as claimed in claim 7, further comprising a biasing network for generating bias voltages for said current sources (I1, I2, I3) and said cascode transistors (M5, M6).

9. A pulse amplifier as claimed in claim 8, wherein the load transistors (M3, M4) are of the same type as said differential transistors.

10. A pulse amplifier as claimed in any preceding claim, further comprising an offset canceling network (4, 5) connected to said input.

11. A pulse amplifier as claimed in claim 10, wherein said offset canceling network comprises an amplifier (5) and a low pass filter (4) having a cut-off frequency below the frequencies contained in said input signal.

12. A pulse amplifier as claimed in claim 7, wherein said amplifier stages (1) have variable gain, and said third current source (I3) is variable.

13. A pulse amplifier as claimed in any preceding claim, wherein said current sources (I1, I2, I3) are current mirrors.

14. A pulse amplifier as claimed in any of claims 1 to 13, wherein said current sources (I1, I2, I3) are cascoded current mirrors.

## Patentansprüche

1. Pulsverstärker, der einen Eingang (EIN) zum Empfang von Eingangssignalen, einen Ausgang (AUS), eine Mehrzahl von in Kaskade geschalteten völlig differenzierten Verstärkerstufen (1) zwischen dem Eingang und dem Ausgang umfaßt, wobei jede Verstärkerstufe (1) einen ersten und einen zweiten Transistor (M1, M2) umfaßt, die ein Differentialpaar bilden und einen gemeinsamen Knoten (GK) haben, sowie ein Paar von mit dem jeweiligen ersten und zweiten Transistor (M1, M2) in Serie geschalteten Kaskodentransistoren (M5, M6), wobei jeder der Transistoren (M1, M2, M5, M6) eine erste und eine zweite Hauptelektrode und eine Gate-Elektrode aufweist, wobei die Gate-Elektroden des ersten und des zweiten Transistors Eingangssignale (EIN+, EIN-) für die Verstärkerstufe (1) empfangen, und die zweiten Hauptelektroden des ersten und zweiten Transistors (M1, M2) an den ersten Hauptelektroden der jeweiligen Kaskodentransistoren (M5, M6) angeschlossen sind, **dadurch gekennzeichnet, daß** der Verstärker (1) ferner eine erste Serienkombination umfaßt, die einen ersten, mit einer ersten Stromquelle (11) in Serie geschalteten Lasttransistor (M3) mit einem ersten gemeinsamen Anschlußpunkt aufweist, sowie eine zweite Serienkombination, die einen zweiten, mit einer zweiten Stromquelle (12) in Serie geschalteten Lasttransistor mit einem zweiten gemeinsamen Anschlußpunkt, wobei der erste und der zweite gemeinsame Anschlußpunkt Ausgangssignale für die Verstärkerstufe liefern und an den zweiten Hauptelektroden der jeweiligen Kaskodentransistoren angeschlossen sind, und wobei in Anwesenheit starker Eingangssignale einer der Transistoren (M1 oder M2) des Differentialpaares zur Stromleitung gezwungen wird, wodurch die erste Hauptelektrode des assoziierten Kaskodentransistors (M5 oder M6) wesentlich an den gemeinsamen Knoten (GK) kurzgeschlossen wird, wodurch die Spannung der ersten Hauptelektrode des assoziierten Kaskodentransistors (M5 oder M6) sich der Gate-Spannung annähert, und der Stromfluß durch den assoziierten Kaskodentransistor (M5 oder M6) schrittweise sinkt, und daher auch der Stromfluß durch einen der Transistoren (M1 oder 2) des Differentialpaares (M1, M2), der zur Stromleitung gezwungen wurde.

2. Pulsverstärker nach Anspruch 1, wobei die erste und die zweite Stromquelle (11, 12) mit den Serienkombinationen der ersten und zweiten Transistoren (M1, M2) und deren assoziierten Kaskodentransistoren (M5, M6) in Serie geschaltet sind, und der erste und der zweite Lasttransistor (M3, M4) mit den Serienkombinationen der ersten und zweiten Transistoren (M1, M2) und deren assoziierten Kaskodentransistoren (M5, M6) parallel geschaltet sind.

3. Pulsverstärker nach Anspruch 1, wobei die erste und die zweite Stromquelle (11, 12) mit den Serienkombinationen der ersten und zweiten Transistoren (M1, M2) und deren assoziierten Kaskodentransistoren (M5, M6) parallel geschaltet sind, und der erste und der zweite Lasttransistor (M3, M4) mit den Serienkombinationen der ersten und zweiten Transistoren (M1, M2) und deren assoziierten Kaskodentransistoren (M5, M6) in Serie geschaltet sind.

4. Pulsverstärker nach Anspruch 1, wobei die Gates der Kaskodentransistoren (M5, M6) an einer Spannungsquelle (V_{B}) angeschlossen sind, und die Spannungsquelle so gewählt ist, daß die Quellen-Drain-Spannung des Differentialpaares etwas höher als ihre Sättigungsspannung liegt, solange die Verstärkerstufe infolge großer Eingangssignale nicht die Höchstpunkte begrenzt.

5. Pulsverstärker nach einem der Ansprüche 1 bis 4, wobei die erste Hauptelektrode die Quelle ist und die zweite Hauptelektrode der Drain ist.

6. Pulsverstärker nach Anspruch 5, wobei er ferner eine dritte in Serie mit dem gemeinsamen Knoten geschaltete Stromquelle (13) umfaßt.

7. Pulsverstärker nach Anspruch 6, wobei die von den ersten und zweiten Stromquellen (11, 12) erzeugten Ströme grösser als der von der dritten Stromquelle (13) erzeugte Strom sind, um sicherzustellen, daß Strom durch die Lasttransistoren strömt, wenn der erste und der zweite Transistor gesättigt sind.

8. Pulsverstärker nach Anspruch 7, wobei er ferner ein Vorspannungsnetzwerk zur Erzeugung von Vorspannung für die Stromquellen (11, 12, 13) und die Kaskodentransistoren (M5, M6) umfaßt.

9. Pulsverstärker nach Anspruch 8, wobei die Lasttransistoren (M3, M4) desselben Typs wie die Differentialtransistoren sind.

10. Pulsverstärker nach einem der vorangehenden Ansprüche, wobei er ferner ein an dem Eingang angeschlossenes fehlspannungausgleichendes Netzwerk (4, 5) umfaßt.

11. Pulsverstärker nach Anspruch 10, wobei das fehlspannungausgleichende Netzwerk einen Verstärker (5) und einen Tiefpaßfilter (4) mit einer Grenzfrequenz umfaßt, die unter den in den Eingangssignalen enthaltenen Frequenzen liegt.

12. Pulsverstärker nach Anspruch 7, wobei die Verstärkerstufen (1) einen variablen Verstärkungsfaktor besitzen, und die dritte Stromquelle (13) variabel ist.

13. Pulsverstärker nach einem der vorangehenden Ansprüche, wobei die Stromquellen (11, 12, 13) Stromspiegel sind.

14. Pulsverstärker nach einem der Ansprüche 1 bis 13, wobei die Stromquellen (11, 12, 13) Kaskoden-Stromspiegel sind.

## Revendications

1. Amplificateur d'impulsions comprenant une entrée (EN) pour la réception des signaux d'entrée, une sortie (SOR), ainsi qu'une pluralité d'étages amplificateurs entièrement différentiels (1) entre lesdites entrée et sortie, chaque étage amplificateur (1) comprenant des transistors premier et deuxième (M1, M2) qui forment une paire différentielle et ont un noeud commun (CN), ainsi qu'une paire de transistors cascodes (M5, M6) en série avec lesdits premier et deuxième transistors respectifs (M1, M2), chacun desdits transistors (M1, M2, M5, M6) ayant des première et deuxième électrodes principales ainsi qu'une électrode porte, les électrodes portes desdits premier et deuxième transistors recevant des signaux d'entrée (EN+, EN-) pour l'étage amplificateur (1), les deuxièmes électrodes principales desdits premier et deuxième transistors (M1, M2) étant reliés aux premières électrodes principales desdits transistors cascodes respectifs (M5, M6), **caractérisé en ce que** ledit amplificateur (1) comprend aussi une première combinaison en série comprenant un premier transistor de charge (M3) en série avec un première source de courant (I1) et ayant un premier point de connexion commun, et une deuxième combinaison en série comprenant un deuxième transistor de charge en série avec une deuxième source de courant (I2) et ayant un deuxième point de connexion commun, lesdits premier et deuxième points de connexion fournissant des signaux de sortie pour ledit étage amplificateur et étant reliés aux secondes électrodes principales desdits transistors cascodes respectifs et où, en la présence d'importants signaux d'entrée, un des transistors (M1 ou M2) de ladite paire différentielle est mené fortement à conduction, ce qui fait que la première électrode principale dudit transistor cascade associé (M5 ou M6) est substantiellement court-circuitée audit noeud commun (NC), amenant ainsi la tension de la première électrode principale du transistor cascode associé (M5 ou M6) à s'approcher de sa tension porte, et à son tour amenant une réduction progressive de l'intensité de courant à travers ledit transistor cascode associé (M5 ou M6) et, par conséquent, une réduction progressive dans l'intensité de courant à travers l'un (M1 ou M2) desdits transistors de la paire différentielle (M1, M2) qui a été fortement menée à conduction.

2. Amplificateur d'impulsions selon la revendication 1, **caractérisé en ce que** lesdites première et deuxième sources de courant (I1, I2) sont reliées en série auxdites combinaisons en série desdits premier et deuxième transistors (M1, M2) et leurs transistors cascodes associés (M5, M6), et lesdits premier et deuxième transistors de charge (M3, M4) sont reliés en parallèle auxdites combinaisons en série desdits premier et deuxième transistors (M1, M2) et leurs transistors cascodes associés (M5, M6).

3. Amplificateur d'impulsions selon la revendication 1, **caractérisé en ce que** lesdites première et deuxième sources de courant (I1, I2) sont reliées en parallèle auxdites combinaisons en série desdits premier et deuxième transistors (M1, M2) et leurs transistors cascodes associés (M5, M6), et lesdits premier et deuxième transistors de charge (M3, M4) sont reliés en série auxdites combinaisons en série desdits premier et deuxième transistors (M1, M2) et leurs transistors cascodes associés (M5, M6).

4. Amplificateur d'impulsions selon la revendication 1, **caractérisé en ce que** les portes des transistors cascodes (M5, M6) sont reliées à une source de tension (V_{B}) choisie pour établir la source-tension de drain de ladite paire différentielle légèrement au-dessus de leur tension de saturation du moment que l'étage amplificateur n'est pas écrêté en raison de signaux d'entrée importants.

5. Amplificateur d'impulsions selon les revendications 1 à 4, **caractérisé en ce que** la première électrode principale est la source, et ladite deuxième électrode principale est le drain.

6. Amplificateur d'impulsions selon la revendication 5, qui comprend aussi une troisième source de courant (I3) en série avec ledit noeud commun.

7. Amplificateur d'impulsions selon la revendication 6, **caractérisé en ce que** les courants produits par lesdites première et deuxième sources de courant (I1, I2) sont plus grands que le courant produit par ladite troisième source de courant (13) afin de s'assurer que le courant traverse lesdits transistors de charge quand lesdits premier et deuxième transistors sont saturés.

8. Amplificateur d'impulsions selon la revendication 7, qui comprend aussi un réseau de polarisation pour produire des tensions de polarisation pour lesdites sources de courant (I1, I2, I3) et lesdits transistors cascodes (M5, M6).

9. Amplificateur d'impulsions selon la revendication 8, **caractérisé en ce que** les transistors de charge (M3, M4) sont du même type que lesdits transistors différentiels.

10. Amplificateur d'impulsions selon l'une quelconque des revendications précédentes, qui comprend aussi un réseau de suppression des décalages (4, 5) relié à ladite entrée.

11. Amplificateur d'impulsions selon la revendication 10, **caractérisé en ce que** ledit réseau de suppression des décalage comprend un amplificateur (5) et un filtre passe-bas (4) ayant une fréquence de coupure au-dessous des fréquences contenues dans ledit signal d'entrée.

12. Amplificateur d'impulsions selon la revendication 7, **caractérisé en ce que** lesdits étages amplificateurs (1) ont un gain variable, et ladite troisième source de courant (I3) est variable.

13. Amplificateur d'impulsions selon l'une quelconque des revendications précédentes, **caractérisé en ce que** lesdites sources de courant (I1, I2, I3) sont des miroirs de courant.

14. Amplificateur d'impulsions selon l'une quelconque des revendications 1 à 13, **caractérisé en ce que** les sources de courant (I1, I2, I3) sont des miroirs de courant cascodes.
